# EUROPEAN PATENT APPLICATION

(11) **EP 4 006 081 A1**
(43) Date of publication of application: **01.06.2022**
(21) Application number: 21210162.0
(22) Date of filing: 24.11.2021
(51) Int. Cl.: C08G 77/04, C08G 77/14, C08L 63/00, C08G 77/34, H05K 1/03

(54) **DIELECTRIC PROPERTY-LOWERING AGENT, LOW-DIELECTRIC RESIN COMPOSITION CONTAINING SAME AND METHOD FOR LOWERING DIELECTRIC PROPERTIES OF RESIN**

(30) Priority: 26.11.2020 JP 2020196017; 14.04.2021 JP 2021068111
(71) Applicant: SHIN-ETSU CHEMICAL CO., LTD., Tokyo (JP)
(72) Inventor: NYUUGAKU, Takeshi, Joetsu-shi (JP)
(74) Representative: Ter Meer Steinmeister & Partner

(57) **Abstract**

A dielectric property-lowering agent is composed of a specific epoxy-modified silicone resin having a low relative permittivity and a low dielectric loss tangent, and has an ionic species content of less than 0.001 wt%.

## Description

### CROSS-REFERENCE TO RELATED APPLICATION

This non-provisional application claims priority under 35 U.S.C. §119(a) on Patent Application Nos. 2020-196017 and 2021-068111 filed in Japan on November 26, 2020 and April 14, 2021, respectively, the entire contents of which are hereby incorporated by reference.

### TECHNICAL FIELD

The present invention relates to a dielectric property-lowering agent, a low-dielectric resin composition containing the same and a method for lowering the dielectric properties of a resin. The invention also relates to the use of such a dielectric property-lowering agent.

### BACKGROUND ART

Thermoset resins such as urethane resins, epoxy resins, silicone resins, urea resins, phenolic resins, unsaturated polyester resins and melamine resins, when heated alone or in the presence of a curing agent, form a crosslinked structure, thereby giving a non-melting and insoluble composition having a three-dimensional network structure. Such resin compositions have excellent interfacial properties, mechanical properties, insulating properties, adhesiveness, weather resistance, impact resistance, corrosion resistance, water resistance, heat resistance, abrasion resistance, chemical resistance and other properties, and are widely used in a broad range of fields, including laminating agents, adhesives, sealants, insulating films, coatings, medical materials, construction materials, molding materials, automotive materials, textile materials and electronic materials.

Of the above thermoset resins, epoxy-modified silicone resins have epoxy groups and a siloxane structure. Hence, when epoxy-modified silicone resins are used, they are able to improve a number of properties of the resin composition, including the interfacial properties, insulating properties, adhesiveness and heat resistance.

Known epoxy-modified silicone resins of this type include bis[(3,4-epoxycyclohexyl)ethyl]polydimethylsiloxane and tetrakis[(3,4-epoxycyclohexyl)ethyl]tetramethylcyclotetrasiloxane (see, for example, JP-A 2007-9086).

There is a strong desire today in the field of information and communications technology (ICT) for, among other things, transmission rates to be raised to ultrahigh speeds in order to keep pace with increases in the volume of information, numerous devices to be connected simultaneously to handle the growing diversity in the forms of information and ultralow latency to better enable remote control. Such desires have created a need for technology that processes large amounts of electrical signals at high speed. This need is being addressed by the adoption of technology which greatly increases the amount of electrical signals transmitted per unit time on transmission circuits by utilizing bands having higher frequencies than those currently in use.

Yet, a problem with high-frequency bands is that the intensity of the electrical signals tends to attenuate and latency tends to occur, leading to transmission loss. Although transmission loss is affected by, among other factors, conductor loss due to the conductor portion of the electronic material making up a transmission line and dielectric loss due to the resin portion, the influence of dielectric loss predominates in high-frequency bands. Dielectric loss, which results from electrical signals that have flowed into the resin portion being converted to heat, is expressed as D = kf√εr·tan δ (where D is the dielectric loss, k is a proportionality constant, f is the frequency, εr is the relative permittivity (often synonymous with "dielectric constant"), and tan δ is the dielectric loss tangent), and is proportional to the relative permittivity and dielectric loss tangent values for the resin.

Accordingly, there is a need in the ICT field for technology that controls the relative permittivity and dielectric loss tangent of resins used in high-frequency bands.

However, the epoxy-modified silicone resin described in JP-A 2007-9086 has a high relative permittivity and a high dielectric loss tangent on account of the higher polarity of the epoxy groups, and so is poorly suited for use in high-frequency bands.

That is, when the siloxane structure of the epoxy-modified silicone resin is a low-molecular-weight oligosiloxane, resin compositions using this resin have a large transmission loss because of the large ratio of epoxy groups in the molecule and the high relative permittivity and high dielectric loss tangent. On the other hand, when the siloxane structure is a high-molecular-weight polydimethylsiloxane, because it exists in the form of a high-viscosity oil, problems such as the inability of the resin composition to cure arise.

There has thus existed a desire for the development of an epoxy-modified silicone resin having a low relative permittivity and a low dielectric loss tangent, and also for the development of a low-dielectric resin composition that has been cured using the same.

### SUMMARY OF THE INVENTION

It is therefore an object of the present invention to provide a dielectric property-lowering agent made of an epoxy-modified silicone resin having a low relative permittivity and a low dielectric loss tangent. As used herein, "dielectric property-lowering agent" refers to a material which, when included in a resin composition, lowers the relative permittivity and the dielectric loss tangent of the composition. A further object of the invention is to provide a low-dielectric resin composition containing the dielectric property-lowering agent. A still further object is to provide a method for lowering the dielectric properties of a resin. An additional object is to provide the use of such a silicone resin as a dielectric property-lowering agent.

As a result of intensive investigations, I have discovered that siloxane compounds of general formula (1) below are epoxy-modified silicone resins having a low relative permittivity and a low dielectric loss tangent. I have also found that when these siloxane compounds have an ionic species content of less than 0.001 wt%, the relative permittivity and the dielectric loss tangent of a resin composition that has been cured using such a siloxane compound decrease.

Accordingly, a first aspect of the invention is directed at a dielectric property-lowering agent which includes a siloxane compound of general formula (1) below 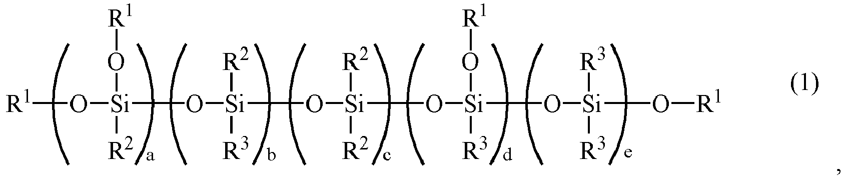 and has an ionic species content of less than 0.001 wt%.
In formula (1),
each R¹ is independently a group of general formula (2) below 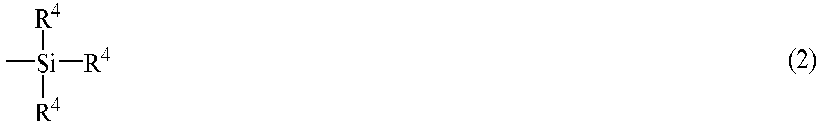 (each R⁴ being independently an unsubstituted monovalent hydrocarbon group of 1 to 10 carbon atoms),
each R² is independently a group of general formula (3) or (4) below 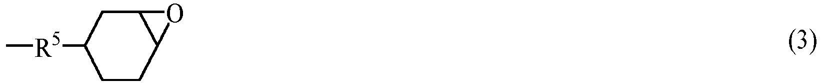 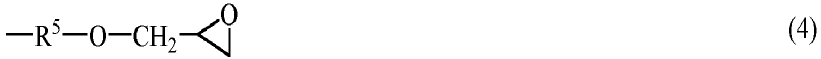 (R⁵ being a substituted or unsubstituted linear, branched or cyclic alkylene group of 1 to 10 carbon atoms),
each R³ is independently a hydrogen atom, an unsaturated monovalent hydrocarbon group of 1 to 10 carbon atoms or a group of general formula (5) below 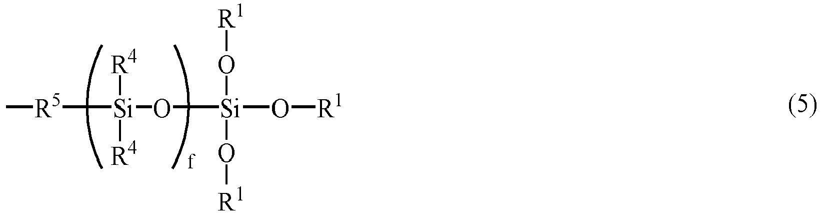 (R¹, R⁴ and R⁵ being as defined above, and f being an integer from 0 to 10), and
the subscripts a, b, c, d and e are each independently integers from 0 to 1 that together satisfy the conditions 1 ≤ a+b+c ≤ 10 and 1 ≤ a+b+c+d+e ≤ 10.

In a preferred embodiment of the dielectric property-lowering agent of the invention, the ionic species is one or more selected from the group consisting of fluoride ions, chloride ions, bromide ions and iodide ions.

In another preferred embodiment, the amount of silicon atoms to which O-R¹ groups are bonded per mole of silicon atoms to which R² groups are bonded is from 2 to 59.

A second aspect of the invention is directed at a low-dielectric resin composition which includes the dielectric property-lowering agent according to the first aspect of the invention and a resin.

A third aspect of the invention is directed at a method for lowering certain dielectric properties of a resin, which method includes the step of using the dielectric property-lowering agent according to the first aspect of the invention.

A fourth aspect of the invention is directed at the use of the siloxane compound according to the first aspect of the invention as a dielectric property-lowering agent.

### ADVANTAGEOUS EFFECTS OF THE INVENTION

The dielectric property-lowering agent of the invention, which is made up of a specific siloxane compound and has a low ionic species content, is characterized by having a low relative permittivity and a low dielectric loss tangent. The relative permittivity and the dielectric loss tangent of resin compositions cured using this agent can be lowered.

### DESCRIPTION OF THE PREFERRED EMBODIMENTS

The objects, features and advantages of the invention will become more apparent from the following detailed description.

### (1) Dielectric Property-Lowering Agent

The dielectric property-lowering agent of the invention is composed of a siloxane compound of general formula (1) below, and has an ionic species content of less than 0.001 wt%.

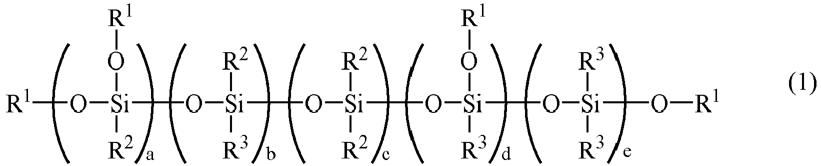

In general formula (1), each R¹ is independently a group of general formula (2) below.

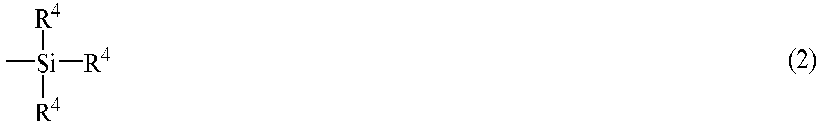

In formula (2), each R⁴ is independently an unsubstituted monovalent hydrocarbon group of 1 to 10 carbon atoms, preferably 1 to 8 carbon atoms, and more preferably 1 to 6 carbon atoms.

The monovalent hydrocarbon group may be linear, branched or cyclic. Specific examples include linear alkyl groups such as methyl, ethyl, n-propyl, n-butyl, n-pentyl, n-hexyl, n-heptyl, n-octyl, n-nonyl and n-decyl groups; branched alkyl groups such as isopropyl, sec-butyl, tert-butyl, sec-pentyl, tert-pentyl, sec-hexyl, tert-hexyl, sec-heptyl, tert-heptyl, sec-octyl, tert-octyl, sec-nonyl, tert-nonyl, sec-decyl and tert-decyl groups; cyclic alkyl groups such as cyclopentyl and cyclohexyl groups; alkenyl groups such as vinyl, allyl, butenyl and methallyl groups; aryl groups such as phenyl, tolyl and xylyl groups; and aralkyl groups such as benzyl and phenethyl groups.

Of these, R⁴ is preferably an unsubstituted linear, branched or cyclic alkyl group of 1 to 6 carbon atoms; an alkenyl group, an aryl group or an aralkyl group. Particularly from the standpoint of precursor availability, unsubstituted linear or branched alkyl groups of 1 to 3 carbon atoms and alkenyl groups are more preferred. Methyl, ethyl, n-propyl and isopropyl groups are even more preferred.

In general formula (1), each R² is independently a group of general formula (3) or (4) below.

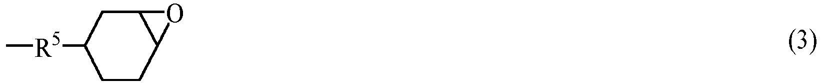

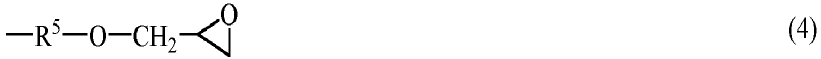

In general formulas (3) and (4), R⁵ represents a substituted or unsubstituted alkylene group of 1 to 10 carbon atoms, preferably 1 to 8 carbon atoms, and more preferably 1 to 6 carbon atoms.

The alkylene group may be linear, branched or cyclic. Specific examples include linear alkylene groups such as methylene, ethylene, trimethylene, tetramethylene, pentamethylene, hexamethylene, heptamethylene and octamethylene groups; branched alkylene groups such as isopropylene, sec-butylene, tert-butylene, sec-pentylene, tert-pentylene, sec-hexylene, tert-hexylene, sec-heptylene, tert-heptylene, sec-octylene and tert-octylene groups; and cyclic alkylene groups such as cyclopropylene, cyclopentylene and cyclohexylene groups.

Some or all of the hydrogen atoms on these alkylene groups may be substituted with other substituents. Specific examples of these substituents include alkoxy groups of 1 to 3 carbon atoms, such as methoxy, ethoxy and (iso)propoxy groups; halogen atoms such as fluorine, chlorine and bromine; aromatic hydrocarbon groups such as phenyl groups; and cyano groups, amino groups, ester groups, ether groups, carbonyl groups, acyl groups and sulfide groups. These may be used singly or two or more may be used in combination. The substitution site for these substituents are not particularly limited, and the number of substituents are also not limited.

These alkylene groups may have, on the molecular chain, one, two or more intervening groups such as ether, ester, carbonyl, sulfide or disulfide groups. Of these, R⁵ is preferably an unsubstituted linear alkylene group of 1 to 8 carbon atoms. Particularly from the standpoint of the precursor availability, unsubstituted linear alkylene groups of 1 to 4 carbon atoms, such as methylene and ethylene groups, are more preferred.

In general formula (1), each R³ is independently a hydrogen atom, an unsubstituted monovalent hydrocarbon group of 1 to 10, preferably 1 to 8, and more preferably 1 to 6 carbon atoms, or a group of general formula (5) below.

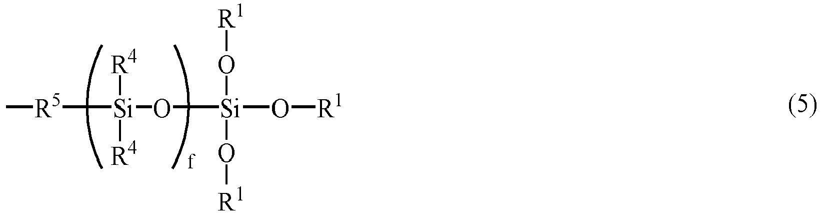

In general formula (5), R¹, R⁴ and R⁵ are exemplified in the same way as the above-mentioned substituents.

Also, the subscript f is an integer from 0 to 10. Particularly from the standpoint of precursor availability, f is preferably an integer from 0 to 3, and is more preferably 0.

Of these, R³ is preferably an unsubstituted linear, branched or cyclic alkyl group of 1 to 6 carbon atoms, an alkenyl group, an aryl group or an aralkyl group. Particularly from the standpoint of the precursor availability, unsubstituted linear or branched alkyl groups of 1 to 3 carbon atoms and alkenyl groups are more preferred. Methyl, ethyl, n-propyl and isopropyl groups are even more preferred.

In general formula (1), the subscripts a, b, c, d and e are each independently integers from 0 to 1 which satisfy the conditions 1 ≤ a+b+c ≤ 10 and 1 ≤ a+b+c+d+e ≤ 10. Particularly from the standpoint of lowering the relative permittivity and the dielectric loss tangent, these preferably satisfy the conditions 1 ≤ a+b+c ≤ 3 and 1 ≤ a+b+c+d+e ≤ 10, and more preferably satisfy the conditions 1 ≤ a+b+c ≤ 1.1 and 1 ≤ a+b+c+d+e ≤ 10.

In general formula (1), from the standpoint of lowering the relative permittivity and the dielectric loss tangent, the amount of silicon atoms to which O-R¹ groups are bonded per mole of silicon atoms to which R² groups are bonded is preferably from 2 to 59, more preferably from 3 to 59, and even more preferably from 4 to 59.

The dielectric property-lowering agent of the invention is typically prepared by subjecting the corresponding hydrosiloxane compound and an alkenyl group-containing epoxy compound to a hydrosilylation reaction using a platinum catalyst.

The hydrosiloxane compound that is used may be suitably selected from among known siloxane compounds having hydrogen atoms on the molecule.

Specific examples include hexamethyltrisiloxane, heptamethyltrisiloxane, (trimethylsiloxy)hexamethyltrisiloxane, octamethyltetrasiloxane, nonamethyltetrasiloxane, (trimethylsiloxy)octamethyltetrasiloxane, decamethylpentasiloxane, undecamethylpentasiloxane, (trimethylsiloxy)decamethylpentasiloxane, dodecamethylhexasiloxane, tridecamethylhexasiloxane, (trimethylsiloxy)dodecamethylhexasiloxane, tetradecamethylheptasiloxane, pentadecamethylheptasiloxane, (trimethylsiloxy)tetradecamethylheptasiloxane, hexadecamethyloctasiloxane, heptadecamethyloctasiloxane, (trimethylsiloxy)hexadecamethyloctasiloxane, octadecamethylnonasiloxane, nonadecamethylnonasiloxane, (trimethylsiloxy)octadecamethylnonasiloxane, eicosamethyldecasiloxane, heneicosamethyldecasiloxane, (trimethylsiloxy)eicosamethyldecasiloxane, docosamethylundecasiloxane, tricosamethylundecasiloxane, (trimethylsiloxy)docosamethylundecasiloxane, tetracosamethyldodecasiloxane, pentacosamethyldodecasiloxane, (trimethylsiloxy)tetracosamethyldodecasiloxane, hexacosamethyltridecasiloxane, heptacosamethyltridecasiloxane and (trimethylsiloxy)hexacosamethyltridecasiloxane.

Particularly from the standpoint of precursor availability, hexamethyltrisiloxane, heptamethyltrisiloxane and (trimethylsiloxy)hexamethyltrisiloxane are preferred.

The alkenyl group-containing epoxy compound that is used may be suitably selected from among known compounds having an alkenyl group and an epoxy group on the molecule.

Specific examples include epoxy compounds having a glycidyl ether structure, such as vinyl glycidyl ether, allyl glycidyl ether, 2-methylallyl glycidyl ether, butenyl glycidyl ether, hexenyl glycidyl ether, octenyl glycidyl ether, 2-ethylhexenyl glycidyl ether and decenyl glycidyl ether; and epoxy compounds having a cycloalkene oxide structure, such as 1,2-epoxy-4-vinylcyclohexane, 1,2-epoxy-4-allylcyclohexane, 1,2-epoxy-4-(2-methylallyl)cyclohexane, 1,2-epoxy-4-butenylcyclohexane, 1,2-epoxy-4-hexenylcyclohexane, 1,2-epoxy-4-octenylcyclohexane and 1,2-epoxy-4-decenylcyclohexane.

Particularly from the standpoint of precursor availability, epoxy compounds having a glycidyl ether structure, such as allyl glycidyl ether and octenyl glycidyl ether, and epoxy compounds having a cycloalkene oxide structure, such as 1,2-epoxy-4-vinylcylohexane and 1,2-epoxy-4-octenylcyclohexane, are preferred.

The alkenyl group-containing epoxy compound is typically prepared by, for example, the method of reacting an epihalohydrin compound with an alcohol compound (epihalohydrin method) and the method of oxidizing an olefin compound using a peroxide (peroxide oxidation method).

In the epihalohydrin method, an organohalogen compound is used as a starting material, and so an ionic species originating from the starting material is present in the epoxy compound following production. On the other hand, in the peroxide oxidation method, an organohalogen compound is not used as a starting material, and so substantially no ionic species is present in the epoxy compound following production.

As mentioned above, the dielectric property-lowering agent of the invention has an ionic species content of less than 0.001 wt%. Therefore, in order to have the ionic species content be low, it is preferable for the alkenyl group-containing epoxy compound to be prepared by the peroxide oxidation method.

By using an alkenyl group-containing epoxy compound prepared by the peroxide oxidation method and reacting it with a hydrosiloxane compound, the ionic species content within the dielectric property-lowering agent can be kept low.

In the method of preparing the dielectric property-lowering agent of the invention, the hydrosiloxane compound and the alkenyl group-containing epoxy compound are used in proportions which are not particularly limited. However, in terms of reactivity and productivity, the amount of the hydrosiloxane compound per mole of the alkenyl group-containing epoxy compound is preferably from 1 to 20 moles, more preferably from 1 to 10 moles, and even more preferably from 1 to 5 moles.

The platinum catalyst that is used may be suitably selected from among known forms of platinum (Pt) and complex compounds in which platinum serves as the central metal.

Specific examples include chloroplatinic acid, alcohol solutions of chloroplatinic acid, such as 2-ethylhexanol solutions of hexachloroplatinic(IV) acid, toluene or xylene solutions of platinum-1,3-divinyl-1,1,3,3-tetramethyldisiloxane complexes, dichlorobisacetonitrile platinum, dichlorobisbenzonitrile platinum and dichlorocyclooctadiene platinum. Catalysts in which platinum black or the like is supported on a support such as alumina, silica or carbon may also be used.

From the standpoint of the level of reactivity in particular, alcohol solutions of chloroplatinic acid, such as a 2-ethylhexanol solution of hexachloroplatinic (IV) acid, and toluene or xylene solutions of a platinum-1,3-divinyl-1,1,3,3-tetramethyldisiloxane complex are preferred.

The amount of platinum catalyst used is not particularly limited, so long as it is an amount that exhibits a catalytic effect on the hydrosilylation reaction. However, from the standpoint of reactivity and productivity, the amount of platinum metal per mole of the alkenyl group-containing epoxy compound is preferably from 0.0000001 to 1 mole, more preferably from 0.000001 to 0.1 mole, and even more preferably from 0.00001 to 0.01 mole.

The reaction temperature of the hydrosilylation reaction is not particularly limited. However, from the standpoint of reactivity and productivity, the reaction temperature is preferably from 50 to 200°C, more preferably from 50 to 150°C, and even more preferably from 50 to 100°C.

The reaction time also is not particularly limited, but is preferably from 1 to 30 hours, more preferably from 1 to 20 hours, and even more preferably from 1 to 10 hours.

The hydrosilylation reaction proceeds even in the absence of a solvent, although it is also possible to use a solvent.

Examples of the solvent include hydrocarbon solvents such as pentane, hexane, cyclohexane, heptane, isooctane, benzene, toluene and xylene; ether solvents such as diethyl ether, tetrahydrofuran and dioxane; ester solvents such as ethyl acetate and butyl acetate; aprotic polar solvents such as acetonitrile and N,N-dimethylformamide; and chlorinated hydrocarbon solvents such as dichloromethane and chloroform. These solvents may be of one type used alone or two or more may be used in combination.

The platinum catalyst used in the hydrosilylation reaction is contained in the reaction mixture obtained from the reaction. The platinum catalyst contained in the reaction mixture markedly worsens the appearance of the reaction mixture due to black discoloration. Another cause is the generation of ionic species from ligands on the platinum catalyst. In addition, when unreacted hydrosiloxane compound remains behind, there is a danger that dehydrogenation will arise.

For the above reasons, following the hydrosilylation reaction, it is preferable to remove the platinum catalyst contained in the reaction mixture.

The method for removing the platinum catalyst contained in the reaction mixture is not particularly limited. Use can be made of treatment techniques such as distillation, column chromatography, rinsing with water, extraction, filtration, and desorption with activated carbon or diatomaceous earth.

The dielectric property-lowering agent of the invention contains an ionic species originating from the above-mentioned starting materials.

Specific examples of the ionic species include fluoride ions, chloride ions, bromide ions and iodide ions.

The ionic species content in the dielectric property-lowering agent of the invention, from the standpoint of lowering the relative permittivity and the dielectric loss tangent, is less than 0.001 wt%. The content is preferably at least 0.000001 wt% and less than 0.001 wt%, more preferably at least 0.00001 wt% and less than 0.001 wt%, and even more preferably at least 0.0001 wt% and less than 0.001 wt%.

The method of measuring the ionic species content is not particularly limited. Use can be made of analytic techniques such as ion chromatography, high-performance chromatography, potentiometric titration and fluorescence spectroscopy.

### (2) Low-Dielectric Resin Composition

The low-dielectric resin composition of the invention includes the above-described dielectric property-lowering agent and a resin.

Specific examples of the resin include thermoset resins such as urethane resins, epoxy resins, silicone resins, urea resins, phenolic resins, unsaturated polyester resins and melamine resins; and thermoplastic resins such as acrylic resins, polyamide resins, polyimide resins, polyurethane resins, polyester resins, polyvinyl chloride resins, polycarbonate resins, polyvinyl acetate resins and polystyrene resins. Of these, from the standpoint of reactivity with the dielectric property-lowering agent, the use of a thermoset resin is preferred, with an epoxy resin or a silicone resin being more preferred.

The urethane resins are exemplified by moisture-curable urethane resins, including aromatic isocyanates such as diphenylmethane diisocyanate and toluene diisocyanate, and aliphatic isocyanates such as hexamethylene diisocyanate and isophorone diisocyanate; polyol-curable urethane resins composed of a polyol and an aromatic isocyanate or aliphatic isocyanate; and segmented urethane resins composed of a polyol and a blocked isocyanate. These urethane resins may be of one type used alone or two or more may be used together in admixture.

Of these, particularly from the standpoint of availability, moisture-curable urethane resins and polyol-curable urethane resins are preferred; moisture-curable urethane resins are more preferred.

Specific examples of epoxy resins include bisphenol A-type epoxy resins, bisphenol F-type epoxy resins, novolak-type epoxy resins, cyclic aliphatic epoxy resins, long-chain aliphatic epoxy resins, heterocyclic epoxy resins, glycidyl ester-type epoxy resins and glycidyl amine-type epoxy resins. These epoxy resins may be of one type used alone, or two or more may be used in admixture.

Of these, particularly from the standpoint of availability, bisphenol A-type epoxy resins, novolak-type epoxy resins and cyclic aliphatic epoxy resins are preferred. Bisphenol A-type epoxy resins are more preferred.

Specific examples of silicone resins include amino-modified silicones, epoxy-modified silicones, carboxy-modified silicones, carbinol-modified silicones, methacryl-modified silicones, mercapto-modified silicones and phenol-modified silicones. These silicone resins may be of one type used alone, or two or more may be used in admixture. Of these, particularly from the standpoint of availability, amino-modified silicones, epoxy-modified silicone and methacryl-modified silicones are preferred; epoxy-modified silicones are more preferred.

Specific examples of phenolic resins include novolak-type phenolic resins, resole-type phenolic resins and rosin-modified phenolic resins. These phenolic resins may be of one type used alone or two or more may be used in admixture. Of these, particularly from the standpoint of availability, novolak-type phenolic resins and resole-type phenolic resins are preferred; resole-type phenolic resins are more preferred.

Specific examples of unsaturated polyester resins include unsaturated acid-type unsaturated polyester resins, aromatic unsaturated acid-type unsaturated polyester resins and aliphatic unsaturated acid-type unsaturated polyester resins. These unsaturated polyester resins may be of one type used alone or two or more may be mixed together.

Of these, particularly from the standpoint of availability, unsaturated acid-type unsaturated polyester resins and aromatic unsaturated acid-type unsaturated polyester resins are preferred; unsaturated acid-type unsaturated polyester resins are more preferred.

To sufficiently lower the relative permittivity and the dielectric loss tangent, the amount of dielectric property-lowering agent added with respect to the resin is preferably from 0.1 to 100 wt%, more preferably from 0.2 to 80 wt%, and even more preferably from 0.5 to 50 wt%.

The relative permittivity of the dielectric property-lowering agent at a frequency of 1 MHz is preferably 4.0 ε or less, more preferably 3.8 ε or less, and even more preferably 3.6 ε or less. At a frequency of 1 GHz, the relative permittivity is preferably 4.4 ε or less, more preferably 4.2 ε or less, and even more preferably 4.0 ε or less.

The dielectric loss tangent of the dielectric property-lowering agent at a frequency of 1 MHz is preferably 0.002 tan δ or less, more preferably 0.001 tan δ or less, and even more preferably 0.0005 tan δ or less. At a frequency of 1 GHz, the dielectric constant is preferably 0.2 tan δ or less, more preferably 0.1 tan δ or less, and even more preferably 0.05 tan δ or less.

The methods used to measure the relative permittivity and the dielectric loss tangent are not particularly limited; use can be made of analytic techniques such as the coaxial probe method, transmission line method, free space method, cavity resonator method, parallel-plate capacitor method or inductance measurement method.

The low-dielectric resin composition of the invention may be cured by adding a known curing agent.

The curing agent is exemplified by aliphatic amine curing agents, aromatic amine curing agents, modified amine curing agents, isocyanate curing agents, blocked isocyanate curing agents, imidazole curing agents, acid anhydride curing agents, phenolic curing agents, polyaminoamide curing agents, polymercaptan curing agents, cationic curing agents and anionic curing agents. These curing agents may be of one type used alone or two or more may be used in admixture.

Of these, particularly from the standpoint of availability, aliphatic amine curing agents, aromatic amine curing agents, imidazole curing agents, acid anhydride curing agents, phenolic curing agents and polyaminoamide curing agents are preferred; aliphatic amine curing agents, aromatic amine curing agents, imidazole curing agents and acid anhydride curing agents are more preferred.

From the standpoint of sufficient curing, the amount of curing agent added with respect to the resin composition is preferably from 0.2 to 2 moles, more preferably from 0.5 to 1.5 moles, and even more preferably from 0.8 to 1.2 moles, per mole of epoxy groups in the resin composition.

In addition, to promote the curing reaction between the resin composition and the curing agent, a known curing accelerator may be added to the low-dielectric resin composition of the invention.

Specific examples of curing accelerators include organophosphorus compounds such as triphenylphosphine and tributylphosphine, quaternary phosphonium salts such as ethyltriphenylphosphonium bromide and tetrabutylphosphonium O,O-diethylphosphorodithioate, 1,8-diazabicyclo[5.4.0]undeca-7-en and the salt of 1,8-diazabicyclo[5.4.0]undeca-7-en with octanoic acid, zinc octanoate, quaternary ammonium salts such as tetrabutylammonium bromide, imidazoles such as 2-methylimidazole and 2-ethyl-4-methylimidazole, amines such as 2,4,6-tris(dimethylaminomethyl)phenol and benzyl dimethylamine, and inorganic fillers such as fused silica, crystalline silica, alumina, boron nitride, aluminum nitride, silicon nitride, magnesia, magnesium silicate and aluminum. These curing accelerators may be of one type used alone, or two or more may be used in admixture.

Of these, particularly from the standpoint of availability, organophosphorus compounds, quaternary ammonium salts, imidazoles and amines are preferred; quaternary ammonium salts, imidazoles and amines are more preferred.

To sufficiently accelerate curing, the amount of curing accelerator added with respect to the resin composition is preferably from 0.001 to 1 wt%, more preferably from 0.001 to 0.5 wt%, and even more preferably from 0.001 to 0.1 wt%.

The method for curing the low-dielectric resin composition of the invention is not particularly limited so long as the resin composition cures. Examples of suitable methods include curing by heating a mixture of the dielectric property-lowering agent and the resin, curing by adding a curing agent and, if necessary, a curing accelerator to a mixture of the dielectric property-lowering agent and the resin, and curing by adding a mixture of the dielectric property-lowering agent and the resin to a curing agent.

Methods for obtaining a cured product of the resin composition include casting, pouring, potting, dipping, drip coating, transfer molding, compression molding, and the formation of a laminate from resin sheets or the like.

The conditions for curing the low-dielectric resin composition of the invention are not particularly limited, so long as they are conditions under which the resin composition cures.

From the standpoint of productivity, the curing temperature is preferably between 20 and 200°C, more preferably between 50 and 150°C, and even more preferably between 80 and 120°C.

From the standpoint of productivity, the curing time is preferably from 1 to 10 hours, more preferably from 1 to 5 hours, and even more preferably from 1 to 3 hours. The curing time should be suitably set in connection with the above curing temperature.

The dielectric property-lowering agent of the invention may be used directly as is, or may be used after dilution in a solvent.

Specific examples of the solvent include hydrocarbon solvents such as pentane, hexane, cyclohexane, heptane, isooctane, benzene, toluene and xylene; ketone solvents such as acetone and methyl isobutyl ketone; alcohol solvents such as methyl alcohol and ethyl alcohol; ether solvents such as diethyl ether, tetrahydrofuran and dioxane; ester solvents such as ethyl acetate and butyl acetate; aprotic polar solvents such as acetonitrile and N,N-dimethylformamide; and chlorinated hydrocarbon solvents such as dichloromethane and chloroform. These solvents may be used singly or two or more may be used in admixture.

Of these, from the standpoint of compatibility with the dielectric property-lowering agent, hydrocarbon solvents, ketone solvents, alcohol solvents, ether solvents and ester solvents are preferred; hydrocarbon solvents, ketone solvents and alcohol solvents are more preferred.

In cases where the dielectric property-lowering agent of the invention is used after dilution in a solvent, although the concentration of the siloxane compound is not particularly limited, from the standpoint of reactivity and productivity, the siloxane compound may be used after dilution in the above solvent to a concentration of preferably from 0.001 to 50 wt%, more preferably from 0.1 to 50 wt%, and even more preferably from 0.1 to 10 wt%.

### (3) Method for Lowering Dielectric Properties, and Use of Siloxane Compound as a Dielectric Property-Lowering Agent

Because the dielectric property-lowering agent of the invention is an epoxy-modified silicone resin having a low relative permittivity and a low dielectric loss tangent, the relative permittivity and dielectric loss tangent of resin compositions cured using this agent can be decreased.

Low-dielectric resin compositions obtained using the dielectric property-lowering agent of the invention are suitable as electronic materials for use in high-frequency bands in the ICT field. Such electronic materials include optical thin films, adhesives, laminates, insulating films, anti-reflective coatings, sealants and printed wiring boards.

### EXAMPLES

The following Examples and Comparative Examples are provided to illustrate the invention, but are not intended to limit the scope thereof.

The purities of the fractions obtained in distillation below are values measured under the following gas chromatography measurement conditions, the ionic species contents were obtained under the titration conditions indicated below, and the relative permittivity and dielectric loss tangent values are values measured under the dielectric constant measurement conditions indicated below.

**Gas Chromatography Measurement Conditions**

| | |
|---|---|
| Gas chromatograph: | GC-2014 (Shimazdu Corporation) |
| Packed column: | Silicone SE-30 (GL Sciences Inc.) |
| Detector: | TCD |
| Detector temperature: | 300°C |
| Injection port temperature: | 300°C |
| Temperature program: | 70°C (0 min) → 10°C/min → 300°C (10 min) |
| Carrier gas: | helium (50 ml/min) |
| Injection rate: | 1 µL |

**Titration Conditions**

| | |
|---|---|
| Titrator: | automatic titrator COM-2000 (Hiranuma Sangyo Co., Ltd.) |
| Titration reagent: | 0.025 N silver nitrate solution (aqueous) |
| Titration solvent: | acetone-methanol mixed solvent |
| Method: | Potentiometric titration |
| Amount of sample: | 2 g |

**Dielectric Constant Measurement Conditions for Dielectric Property-Lowering Agent (parallel-plate capacitor method)**

| | |
|---|---|
| LCR meter: | HP4284A (Keysight Technologies KK) |
| Liquid test fixture: | HP16452A (Keysight Technologies KK) |
| Measurement atmosphere: | room-temperature (24°C) air |
| Frequency: | 1 MHz |
| Reference material: | air |

**Dielectric Constant Measurement Conditions for Dielectric Property-Lowering Agent (coaxial probe method)**

| | |
|---|---|
| Impedance analyzer: | E4991B (Keysight Technologies KK) |
| Dielectric probe kit: | N1501A-101 (Keysight Technologies KK) |
| Measurement atmosphere: | room-temperature (24°C) air |
| Frequency: | 1 GHz |
| Reference materials: | air, 1-butanol |

**Dielectric Constant Measurement Conditions for Resin Composition (parallel-plate capacitor method)**

| | |
|---|---|
| LCR meter: | E4980A (Keysight Technologies KK) |
| Liquid test fixture: | 16451B (Keysight Technologies KK) |
| Measurement atmosphere: | room-temperature (25°C) air |
| Frequencies: | 1 KHz, 1 MHz |
| Reference material: | air |

### (1) Synthesis of Dielectric Property-Lowering Agent

### Example 1-1

### Synthesis of 1,1,1,3,5,5,5-Heptamethyl-3-[2-(3,4-epoxy)-cyclohexylethyl]trisiloxane

A flask equipped with a stirrer, a reflux condenser, a dropping funnel and a thermometer was charged with 124.2 g (1.000 mol) of 1,2-epoxy-4-vinylcyclohexane and a platinum-1,3-divinyl-1,1,3,3-tetramethyldisiloxane complex solution in toluene (0.000010 mol as platinum atoms), and heated to 50°C. After the internal temperature stabilized, 222.5 g (1.000 mol) of 1,1,1,3,5,5,5-heptamethyltrisiloxane was added dropwise over 10 hours and the system was stirred for 2 hours at that temperature.

The system was then cooled to room temperature, following which the resulting reaction mixture was distilled, yielding 338.7 g of a clear colorless fraction having a boiling point of 116 to 117°C at 0.2 kPa. This fraction was analyzed by gas chromatography and the purity of the 1,1,1,3,5,5,5-heptamethyl-3-[2-(3,4-epoxy)-cyclohexylethyl]trisiloxane was confirmed to be 99.9% (0.977 mol; yield, 97.7%).

### Example 1-2

### Synthesis of Mixture of 1,1,1,3,5,5,5-Heptamethyl-3-(3-glycidyloxypropyl)trisiloxane and 1,1,1,3,5,5,5-Heptamethyl-3-[1-methyl-2-(glycidyloxy)ethyl]trisiloxane

A flask equipped with a stirrer, a reflux condenser, a dropping funnel and a thermometer was charged with 114.1 g (1.000 mol) of allyl glycidyl ether and a platinum-1,3-divinyl-1,1,3,3-tetramethyldisiloxane complex solution in toluene (0.000010 mol as platinum atoms), and heated to 50°C. After the internal temperature stabilized, 222.5 g (1.000 mol) of 1,1,1,3,5,5,5-heptamethyltrisiloxane was added dropwise over 10 hours and the system was stirred for 2 hours at that temperature.

The system was then cooled to room temperature, following which the resulting reaction mixture was distilled, yielding 252.5 g of a clear colorless fraction having a boiling point of 105 to 110°C at 0.4 kPa. This fraction was analyzed by gas chromatography and the purity of the mixture of 1,1,1,3,5,5,5-heptamethyl-3-[3-(glycidyloxy)propyl]trisiloxane and 1,1,1,3,5,5,5-heptamethyl-3-[1-methyl-2-(glycidyloxy)ethyl]trisiloxane was confirmed to be 99.9% (0.750 mol; yield, 75.0%).

### Example 1-3

### Synthesis of 1,1,1,5,5,5-Hexamethyl-3-[2-(3,4-epoxy)-cyclohexylethyl]-3-(trimethylsiloxy)trisiloxane

A flask equipped with a stirrer, a reflux condenser, a dropping funnel and a thermometer was charged with 124.2 g (1.000 mol) of 1,2-epoxy-4-vinylcyclohexane and a platinum-1,3-divinyl-1,1,3,3-tetramethyldisiloxane complex solution in toluene (0.000010 mol as platinum atoms), and heated to 50°C. After the internal temperature stabilized, 296.7 g (1.000 mol) of 1,1,1,5,5,5-hexamethyl-3-(trimethylsiloxy)trisiloxane was added dropwise over 10 hours and the system was stirred for 2 hours at that temperature.

The system was then cooled to room temperature, following which 2.0 g of activated carbon was added to the resulting reaction mixture and the system was stirred for 2 hours at that temperature. After stirring, the activated carbon was removed by filtration and vacuum concentration was subsequently carried out at 100°C and 0.1 kPa, giving 391.4 g of a clear colorless solution. The resulting solution was analyzed by gas chromatography and the purity of the 1,1,1,5,5,5-hexamethyl-3-[2-(3,4-epoxy)-cyclohexylethyl]-3-(trimethylsiloxy)trisiloxane was confirmed to be 99.9% (0.930 mol; yield, 93.0%).

### Example 1-4

### Synthesis of Mixture of 1,1,1,5,5,5-Hexamethyl-3-(3-glycidyloxypropyl)-3-(trimethylsiloxy)trisiloxane and 1,1,1,5,5,5-Hexamethyl-3-[1-methyl-2-(glycidyloxy)-ethyl]-3-(trimethylsiloxy)trisiloxane

A flask equipped with a stirrer, a reflux condenser, a dropping funnel and a thermometer was charged with 114.1 g (1.000 mol) of allyl glycidyl ether and a platinum-1,3-divinyl-1,1,3,3-tetramethyldisiloxane complex solution in toluene (0.000010 mol as platinum atoms), and heated to 50°C. After the internal temperature stabilized, 296.7 g (1.000 mol) of 1,1,1,5,5,5-hexamethyl-3-(trimethylsiloxy)trisiloxane was added dropwise over 10 hours and the system was stirred for 2 hours at that temperature.

The system was then cooled to room temperature, following which 2.0 g of activated carbon was added to the resulting reaction mixture and the system was stirred for 2 hours at that temperature. After stirring, the activated carbon was removed by filtration and vacuum concentration was subsequently carried out at 100°C and 0.1 kPa, giving 299.9 g of a clear colorless solution. The resulting solution was analyzed by gas chromatography and the purity of the mixture of 1,1,1,5,5,5-hexamethyl-3-(3-glycidyloxypropyl)-3-(trimethylsiloxy)trisiloxane and 1,1,1,5,5,5-hexamethyl-3-[1-methyl-2-(glycidyloxy)ethyl]-3-(trimethylsiloxy)trisiloxane was confirmed to be 99.9% (0.730 mol; yield, 73.0%).

### (2) Evaluation of Dielectric Property-Lowering Agent Performance

The ionic species content of the 1,1,1,3,5,5,5-heptamethyl-3-[2-(3,4-epoxy)-cyclohexylethyl]trisiloxane obtained in Example 1-1 was determined by potentiometric titration to be 0.00005 wt%.

The ionic species content of the mixture of 1,1,1,3,5,5,5-heptamethyl-3-(3-glycidyloxypropyl)trisiloxane and 1,1,1,3,5,5,5-heptamethyl-3-[1-methyl-2-(glycidyloxy)-ethyl]trisiloxane obtained in Example 1-2 was determined by potentiometric titration to be 0.00008 wt%.

The ionic species content of the 1,1,1,5,5,5-hexamethyl-3-[2-(3,4-epoxy)-cyclohexylethyl]-3-(trimethylsiloxy)trisiloxane obtained in Example 1-3 was determined by potentiometric titration to be 0.00005 wt%.

The ionic species content of the mixture of 1,1,1,5,5,5-hexamethyl-3-(3-glycidyloxypropyl)-3-(trimethylsiloxy)trisiloxane and 1,1,1,5,5,5-hexamethyl-3-[1-methyl-2-(glycidyloxy)ethyl]-3-(trimethylsiloxy)trisiloxane obtained in Example 1-4 was determined by potentiometric titration to be 0.00008 wt%.

The relative permittivity and dielectric loss tangent for the siloxane compound obtained in Example 1-1 were measured by the parallel-plate capacitor method and the coaxial probe method. The results are shown in Table 1.

**Table 1**

| | Frequency | Relative permittivity (εr) | Dielectric loss tangent (tan δ) |
|---|---|---|---|
| Example 1-1 | 1 MHz | 3.9 | 0.00039 |
| | 1 GHz | 3.7 | 0.16 |

The siloxane compound obtained in Example 1-1 has 2 moles of trialkylsilyl groups per mole of silicon atoms to which epoxy groups are bonded, and was confirmed to be an epoxy-modified silicone resin having a low relative permittivity and a low dielectric loss tangent owing to the effect of excess trialkylsilyl groups.

### (3) Preparation of Resin Composition

### Example 2-1

A cured resin composition was prepared by adding, at room temperature, 5 parts by weight of the siloxane compound obtained in Example 1-1 and 10 parts by weight of triethylenetetraamine as the curing agent to 100 parts by weight of the bisphenol A-type epoxy resin available as JER828 (Mitsubishi Chemical; epoxy equivalent weight, approx. 190 g/mol), heating at 100°C for 2 hours and then cooling to room temperature.

### Example 2-2

Aside from changing the amount of siloxane compound to 10 parts by weight, a cured resin composition was prepared in the same way as in Example 2-1.

### Comparative Example 2-1

Aside from not using the siloxane compound, a cured resin composition was prepared in the same way as in Example 2-1.

### (4) Evaluation of Resin Composition Performance

The relative permittivity and dielectric loss tangents of the resin compositions prepared in Examples 2-1 and 2-2 and in Comparative Example 2-1 were measured by dielectric constant measurement using the parallel-plate capacitor method. The results are shown in Table 2.

**Table 2**

| | Frequency | Relative permittivity (εr) | Dielectric loss tangent (tan δ) |
|---|---|---|---|
| Example 2-1 | 1 KHz | 4.3 | 0.0125 |
| | 1 MHz | 4.0 | 0.0173 |
| Example 2-2 | 1 KHz | 3.7 | 0.0076 |
| | 1 MHz | 3.6 | 0.0147 |
| Comparative Example 2-1 | 1 KHz | 4.7 | 0.0155 |
| | 1 MHz | 4.3 | 0.0189 |

The results in Table 2 confirm that the relative permittivity and the dielectric loss tangent for each of the resin compositions prepared in Examples 2-1 and 2-2 which were cured using the siloxane compound obtained in Example 1-1 are both lower that the value for the resin composition prepared in Comparative Example 2-1.

Japanese Patent Application Nos. 2020-196017 and 2021-068111 are incorporated herein by reference.

Although some preferred embodiments have been described, many modifications and variations may be made thereto in light of the above teachings. It is therefore to be understood that the invention may be practiced otherwise than as specifically described without departing from the scope of the appended claims.

## Claims

1. A dielectric property-lowering agent comprising a siloxane compound of general formula (1) below 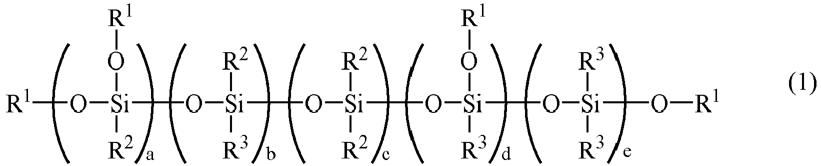 wherein
each R¹ is independently a group of general formula (2) below 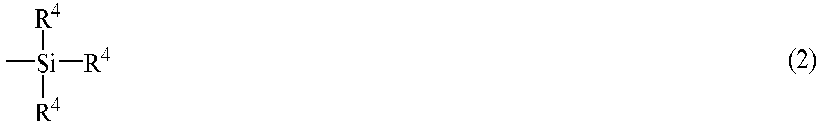 (each R⁴ being independently an unsubstituted monovalent hydrocarbon group of 1 to 10 carbon atoms),
each R² is independently a group of general formula (3) or (4) below 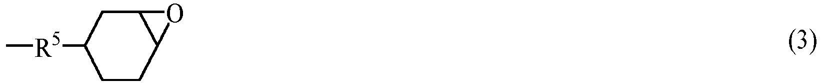 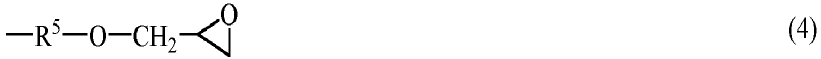 (R⁵ being a substituted or unsubstituted linear, branched or cyclic alkylene group of 1 to 10 carbon atoms),
each R³ is independently a hydrogen atom, an unsaturated monovalent hydrocarbon group of 1 to 10 carbon atoms or a group of general formula (5) below 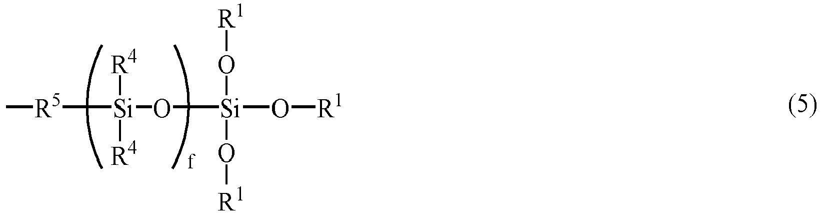 (R¹, R⁴ and R⁵ being as defined above, and f being an integer from 0 to 10), and
the subscripts a, b, c, d and e are each independently integers from 0 to 1 that together satisfy the conditions 1 ≤ a+b+c ≤ 10 and 1 ≤ a+b+c+d+e ≤ 10,
which agent has an ionic species content of less than 0.001 wt%.

2. The dielectric property-lowering agent of claim 1, wherein the ionic species is one or more selected from the group consisting of fluoride ions, chloride ions, bromide ions and iodide ions.

3. The dielectric property-lowering agent of claim 1 or 2, wherein the amount of silicon atoms to which O-R¹ groups are bonded is from 2 to 59 moles per mole of silicon atoms to which R² groups are bonded.

4. A low-dielectric resin composition comprising the dielectric property-lowering agent of any one of claims 1 to 3 and a resin.

5. A resin dielectric property-lowering method comprising the step of using the dielectric property-lowering agent of any one of claims 1 to 3.

6. The use of the siloxane compound of any one of claims 1 to 3 as a dielectric property-lowering agent.
